# FASCICULE DE BREVET EUROPEEN

(11) **EP 3 646 046 B1**
(45) Date de publication et mention de la délivrance du brevet: **15.02.2023**
(21) Numéro de dépôt: 18738220.5
(22) Date de dépôt: 27.06.2018
(51) Int. Cl.: G01R 33/04, G01R 33/09

(54) **DISPOSITIF DE MESURE DE CHAMPS MAGNETIQUES FAIBLES**
VORRICHTUNG ZUR MESSUNG SCHWACHER MAGNETFELDER
DEVICE FOR MEASURING WEAK MAGNETIC FIELDS

(30) Priorité: 28.06.2017 FR 1755972
(43) Date de publication de la demande: 06.05.2020
(73) Titulaire: Centre National de la Recherche Scientifique, 75016 Paris (FR); Université d'Orléans, 45100 Orléans (FR); Commissariat à l'Energie Atomique et aux Energies Alternatives, 75015 Paris (FR)
(72) Inventeur: CAVOIT, Claude, 58320 Parigny les Vaux (FR); BARADUC, Claire, 38850 Chirens (FR); SABON, Philippe, 38430 Moirans (FR); BOCHEUX, Amandine, 38100 Grenoble (FR); PREJBEANU, Ioan-Lucian, 38170 Seyssinet Pariset (FR)
(74) Mandataire: IPAZ
(86) Numéro de dépôt international: PCT/EP2018/067180
(87) Numéro de publication internationale: WO 2019/002334

(56) Documents cités:
- WO-A1-2012/116933
- FR-A1- 2 943 795
- US-A- 5 452 163
- US-A1- 2004 100 855
- US-A1- 2006 043 960
- US-A1- 2013 164 549

## Description

### Domaine

La présente demande concerne un instrument de mesure, en particulier un dispositif de mesure de champs magnétiques faibles.

### Exposé de l'art antérieur

Certaines applications, par exemple des applications spatiales telles que la mesure de champs magnétiques de planètes, ou certaines méthodes de prospection géophysique ou de contrôle non destructif de structure mécanique, requièrent de détecter ou de mesurer des champs magnétiques faibles, c'est-à-dire inférieurs à un picotesla, voire inférieurs à 100 femto-teslas.

La demande de brevet WO 2012/116933 décrit un dispositif de mesure de champ magnétique ayant une pluralité de capteurs de champ et une pluralité de concentrateurs de flux magnétique couplées aux capteurs de champ magnétique.

La demande de brevet US 2006/0043960 décrit un capteur de courant pour mesurer un champ électrique circulant le long d'une barre de courant. Le capteur de courant suivant cette demande de brevet comprend un noyau magnétique comprenant une ouverture dans laquelle est positionnée la barre de courant.

Le document US 2004/100855 décrit un élément à effet de magnéto-résistance comprenant une succession de couches ferromagnétiques.

Le document US 5452163 décrit un capteur de champ magnétique comprenant un empilement de couches ferromagnétiques.

Le document US 2013/164549 décrit une magnétorésistance géante comprenant un empilement de couches ferromagnétiques.

Le brevet EP 2411825 décrit un dispositif de mesure et/ou de détection d'un tel champ magnétique faible. La figure 1 représente de manière simplifiée le dispositif de la figure 4 de ce brevet.

Le dispositif comprend un circuit magnétique 100 fermé comportant deux branches 102A et 102B sensiblement parallèles. Le circuit comporte en outre des générateurs 104 de flux d'induction magnétiques produisant des flux HA dans la branche 102A et HB dans la branche 102B qui circulent en sens opposés dans les branches 102A et 102B. Les générateurs sont alimentés

par une même tension alternative entre un potentiel VAC et la masse GND. Chacune des branches 102A, 102B comprend un entrefer dans lequel est disposé un capteur de champ magnétique, respectivement 106A, 106B. Les capteurs 106A et 106B sont reliés à des circuits de détection synchrone (SYNC), respectivement 108A et 108B, à la fréquence de la tension alternative. Les sorties des circuits de détection synchrone sont soustraites l'une de l'autre par un amplificateur opérationnel 110. On obtient à la sortie de l'amplificateur 110 une mesure de la composante Hx parallèle aux branches 102A et 102B d'un champ magnétique à mesurer.

Les capteurs proposés dans le brevet susmentionné présentent divers problèmes de réalisation, d'encombrement et de mise en oeuvre.

### Résumé

Ainsi, un mode de réalisation prévoit un dispositif palliant tout ou partie des inconvénients du dispositif décrit ci-dessus.

Un mode de réalisation prévoit un dispositif de mesure de champs magnétiques faibles particulièrement sensible.

Un mode de réalisation prévoit un dispositif de mesure de champs magnétiques faibles comprenant des capteurs simples à réaliser, faciles à intégrer dans le dispositif et faciles à mettre en oeuvre.

Ainsi, un mode de réalisation prévoit un dispositif tel que défini dans la revendication 1.

Selon un mode de réalisation, chacun desdits empilements est disposé entre deux couches conductrices dont chacune est en contact avec l'une des couches ferromagnétiques.

Selon un mode de réalisation, les couches ferromagnétiques ont des épaisseurs comprises entre 3 et 20 nm.

Selon un mode de réalisation, chacune des couches ferromagnétiques comprend une couche comprenant du cobalt (202-1, 204-1) en contact avec la couche tunnel.

Selon un mode de réalisation, chacune des couches ferromagnétiques comprend un alliage à base de nickel, de cobalt et/ou de fer.

Selon un mode de réalisation, ledit alliage est le Ni80Fe20, le NiFeCo ou le FeCoB.

Selon un mode de réalisation, la couche tunnel comprend un oxyde d'un matériau choisi dans le groupe comprenant l'aluminium, le magnésium, l'hafnium et le zirconium.

Selon un mode de réalisation, chacun des empilements a une forme allongée vu de dessus.

Selon un mode de réalisation, chacun desdits empilements vu de dessus a un rapport d'aspect compris entre 1 et 3.

Selon un mode de réalisation, chacun des capteurs, comprend des empilements supplémentaires identiques audit empilement, les empilements étant disposés entre deux couches conductrices communes en contact avec les couches ferromagnétiques.

Selon un mode de réalisation, chacun des capteurs, comprend des empilements supplémentaires identiques audit empilement, reliés en série.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, décrite précédemment, représente schématiquement un dispositif de mesure de champs magnétiques faibles ;
la figure 2 illustre schématiquement un mode de réalisation d'un dispositif de mesure de champs magnétiques faibles, comprenant des exemples de capteurs représentés en perspective ;
la figure 3 est une vue en coupe, partielle et schématique, illustrant un exemple de capteur d'un dispositif de mesure de champs magnétiques faibles ;
les figures 4A, 4B et 4C sont des vues de dessus schématiques d'exemples de capteurs de dispositifs de mesure de champs magnétiques faibles ; et
la figure 5 est une vue schématique en perspective d'un autre exemple de capteur d'un dispositif de mesure de champs magnétiques faibles.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, dans les dispositifs de mesure et de détection synchrone décrits, les générateurs de flux magnétiques alternatifs, les circuits magnétiques, les circuits de mesure et de détection synchrone, ne sont pas décrits en détail, la réalisation de ces éléments étant à la portée de l'homme de l'art à partir des caractéristiques fonctionnelles données dans la présente description.

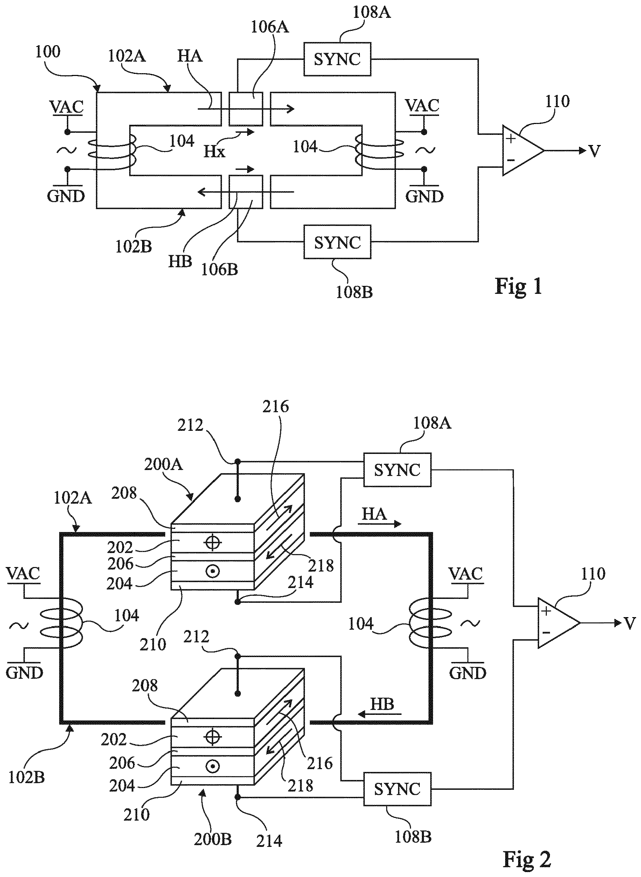

Dans la description qui suit, lorsque l'on fait référence à des qualificatifs de position absolue, tels que les termes "avant", "arrière", etc., ou relative, tels que les termes "dessus", "dessous", "supérieur", etc., il est fait référence à l'orientation de l'élément concerné dans les figures 2, 3 et 5, étant entendu que, dans la pratique, les dispositifs décrits peuvent être orientés différemment. Sauf précision contraire, l'expression "sensiblement" signifie à 10 % près, de préférence à 5 % près, ou, s'agissant d'une orientation, à 10 degrés près, de préférence à 5 degrés près.

La figure 2 illustre schématiquement un mode de réalisation d'un dispositif de mesure de champs magnétiques faibles. Le dispositif de mesure correspond au dispositif de la figure 1, dans lequel les capteurs 106A et 106B ont été remplacés par des capteurs de champ magnétique 200A et 200B, représentés schématiquement en perspective avec des dimensions exagérées. Ainsi, les capteurs 200A et 200B sont situés dans deux branches 102A et 102B sensiblement parallèles d'un circuit magnétique en boucle, représenté de manière simplifiée. Le dispositif comprend des générateurs de flux magnétiques, par exemple des bobines 104 disposées de telle sorte que des flux HA et HB circulent dans les branches 102A et 102B. Les bobines peuvent être disposées par exemple autour de parties du circuit magnétique reliant les extrémités des branches 102A et 102B, ou peuvent être disposées à proximité du circuit magnétique. A titre d'exemple, chacune des bobines 104 est reliée à la masse GND et à un noeud d'application d'un potentiel d'alimentation alternatif VAC, les bobines étant ainsi alimentées en parallèle. Les bobines peuvent aussi être en série, ou être constituées de plusieurs bobines en combinaison parallèle-série. Chacun des capteurs 200A, 200B est relié à un circuit de mesure et de détection synchrone (SYNC), respectivement 108A, 108B. Les sorties des circuits 108A et 108B sont reliées à l'entrée d'un circuit de soustraction, par exemple un amplificateur opérationnel 110.

Chacun des capteurs 200A et 200B comprend un empilement de deux couches ferromagnétiques 202 et 204 séparées par une couche de barrière isolante tunnel 206. Chacune des couches ferromagnétiques 202, 204 peut être en contact avec une couche conductrice électriquement, respectivement 208, 210, reliée à une borne, respectivement 212, 214. Les bornes 212 et 214 de chaque capteur sont reliées au circuit de mesure et de détection synchrone associé au capteur.

Les couches ferromagnétiques 202 et 204 ont des aimantations 216, 218 orientées dans le plan des couches. En l'absence de flux magnétique dans le circuit magnétique et en l'absence de champ magnétique à mesurer, les aimantations 216 et 218 ont des orientations antiparallèles, sensiblement orthogonales à la direction des branches 102A et 102B du circuit magnétique. Bien qu'en figure 2, dans chacun des capteurs 200A et 200B, les aimantations 216 et 218 soient orientées respectivement vers l'arrière et vers l'avant de la figure, les aimantations peuvent prendre d'autres orientations sensiblement orthogonales à la direction des branches 102A et 102B, par exemple les aimantations 216 et 218 peuvent être orientées respectivement vers l'avant et vers l'arrière de la figure dans le capteur 200A et/ou dans le capteur 200B.

On propose ici des capteurs comprenant pour seuls éléments ferromagnétiques les deux couches ferromagnétiques 202 et 204. Dans chaque capteur, on obtient un couplage antiparallèle des aimantations 216 et 218 par la seule influence directe de ces aimantations l'une sur l'autre, sans l'intermédiaire d'éléments ferromagnétiques ou ferrimagnétiques supplémentaires. Le couplage magnétique entre les aimantations des couches est essentiellement de type magnétostatique.

En fonctionnement et en présence d'un champ magnétique à mesurer, l'orientation des aimantations des couches ferromagnétiques de chaque capteur n'est influencée, en plus du couplage antiparallèle, que par le flux magnétique circulant dans le circuit magnétique (créé par le générateur de flux magnétique), par un flux magnétique de rétroaction (voir ci-dessous) et par le champ magnétique à mesurer. Ainsi, le flux magnétique dans le circuit magnétique et le champ à mesurer provoquent une déviation des aimantations 216 et 218 dans chacun des capteurs. Cette déviation est perçue par le circuit de mesure et de détection synchrone associé, dont un rôle est de mesurer la résistance entre les bornes 212 et 214 du capteur considéré dans le sens orthogonal au plan des couches. L'amplificateur opérationnel 110 fournit alors un signal de mesure du champ magnétique à mesurer. Selon l'invention, chaque bobine est alimentée par la somme du potentiel VAC et d'un potentiel de rétroaction représentatif du potentiel de sortie de l'amplificateur 110. Un flux magnétique de rétroaction s'ajoute alors aux flux magnétiques HA et HB.

La surface des couches ferromagnétiques 206 et 208 est de préférence élevée pour obtenir un rapport signal sur bruit élevé.

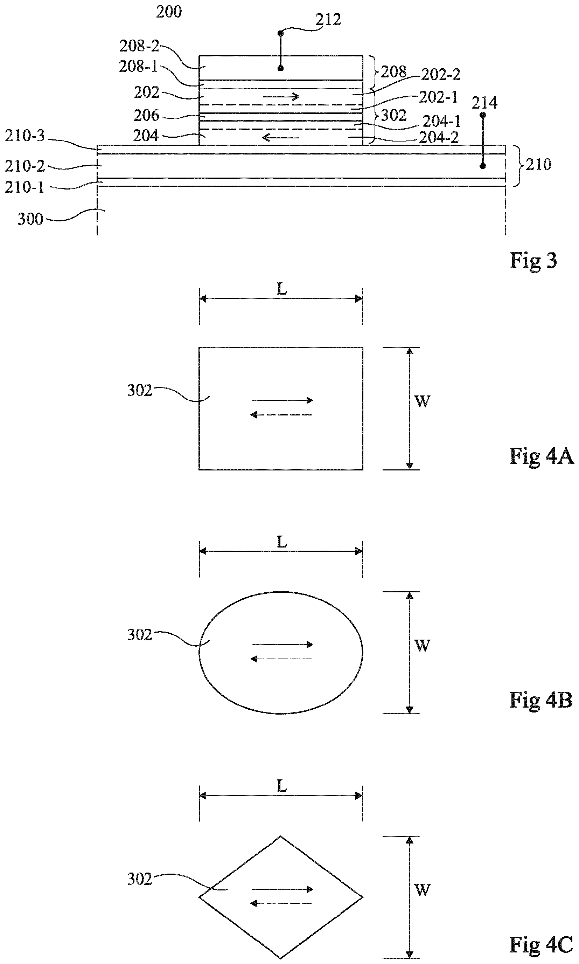

Selon un avantage, l'utilisation dans chaque capteur de deux couches ferromagnétiques séparées par une couche tunnel, dont les aimantations sont couplées antiparallèlement en l'absence d'éléments ferromagnétiques supplémentaires, permet d'obtenir un dispositif de mesure de champs magnétiques faibles ayant une sensibilité particulièrement élevée. En effet, la couche tunnel 206 est prévue entre les couches ferromagnétiques 202 et 204 pour limiter le couplage d'échange entre les couches 202 et 204. L'influence des aimantations 216 et 218 l'une sur l'autre est alors essentiellement déterminée par la forme et les dimensions des empilements de couches 202, 204 et 206. On peut choisir pour ces empilements des formes et dimensions telles que celles qui seront décrites ci-dessous en relation avec les figures 3, 4A, 4B et 4C. Le couplage magnétostatique doit être suffisant pour obtenir une configuration antiparallèle des aimantations 216 et 218 en l'absence de champ autour du capteur. De plus, les variations d'intensité de couplage avec l'orientation de l'aimantation doivent être suffisamment faibles pour que des valeurs de champ magnétique total de l'ordre d'une centaine de pT autour du capteur suffisent à dévier significativement les aimantations 216 et 218 par rapport à la configuration antiparallèle. Les capteurs de champ magnétique 200A et 200B sont donc particulièrement sensibles, et sont ainsi particulièrement adaptés à être utilisés dans un dispositif de mesure de champs magnétiques faibles.

Selon un autre avantage, en raison de l'absence d'élément ferromagnétique ou ferrimagnétique supplémentaire dans chaque capteur, chaque capteur est particulièrement simple à réaliser et à intégrer dans le dispositif, contrairement à des capteurs tels que ceux décrits dans le brevet EP 2411825 susmentionné ou dans les brevets US 8015694 et US 7974048.

Selon un autre avantage, du fait que les orientations des aimantations 216 et 218 sont quasiment antiparallèles en l'absence de champ à mesurer et de flux magnétique dans le circuit magnétique, la résistance entre les bornes 212 et 214 pour un champ magnétique donné environnant le capteur est la même que pour un champ magnétique de même intensité et de sens opposé. Ainsi, contrairement à des capteurs tels que les détecteurs d'orientation de champ magnétique des brevets US 8015694 et US 7974048 susmentionnés, les capteurs 200A et 200B sont sensibles à l'intensité d'un champ magnétique quel que soit son sens. De ce fait, pour un champ à mesurer nul, lorsqu'un flux magnétique alternatif est appliqué au circuit magnétique, la résistance entre les bornes 212 et 214 prend des mêmes valeurs au cours des alternances positive et négative successives. Ces valeurs se compensent facilement par soustraction au cours des traitements réalisés par les circuits de mesure et de détection synchrone 108A, 108B et par le circuit de soustraction 110, ce qui permet d'obtenir une valeur mesurée nulle lorsque le champ à mesurer est nul. En particulier, on peut se passer de circuits supplémentaires destinés à réaliser cette compensation, tels que divers montages en pont de Wheatstone utilisés dans le brevet EP 2411825. De ce fait, les capteurs 200A et 200B sont particulièrement faciles à mettre en oeuvre dans le dispositif, et permettent facilement d'obtenir des mesures particulièrement précises.

On notera que, pour chacun des capteurs 200A et 200B, lorsqu'aucun champ n'est appliqué au capteur, deux états d'aimantation sont possibles pour les couches 202 et 204. L'état représenté en figure 2 correspond à une aimantation 216 orientée vers l'arrière de la figure et une aimantation 218 orientée vers l'avant de la figure. Un autre état est possible, dans lequel les sens des aimantations 216 et 218 sont inversés. Du fait que les aimantations sont antiparallèles en l'absence de champ appliqué au capteur, ces deux états possibles produisent la même valeur de résistance entre les bornes 212 et 214, et on peut se passer de circuits électroniques supplémentaires destinés à distinguer ces deux états.

La figure 3 est une vue en coupe, partielle et schématique, illustrant un exemple de capteur 200 pouvant être utilisé en tant que capteur 200A ou 200B du dispositif de mesure de la figure 2.

Le capteur 200 comprend, sur un support 300, une couche conductrice 210. A titre d'exemple, la couche conductrice 210 est un tricouche de tantale 210-1, d'un alliage non ferromagnétique de nitrure de cuivre 210-2, et de tantale 210-3. Sur la couche conductrice 210, un plot 302 comporte un empilement de portions superposées d'une couche ferromagnétique 204, d'une couche tunnel 206, et d'une couche ferromagnétique 202. A titre d'exemple, le plot 302 est recouvert d'une couche conductrice 208. Comme ceci sera illustré en figures 4A, 4B et 4C, les portions de couches 204, 202 et 206 ont en vue de dessus des formes sensiblement identiques, ainsi que, dans cet exemple, la couche conductrice 208. La couche conductrice 210 est connectée à une borne 214 et la couche conductrice 208 est connectée à une borne 212. A titre d'exemple, la couche conductrice 208 est un bicouche de tantale 208-1 et d'un alliage non ferromagnétique 208-2, par exemple de l'aluminium.

Les seuls éléments ferromagnétiques de l'empilement ainsi obtenu sont les couches 202 et 204. Les couches ferromagnétiques 202 et 204 peuvent être formées par une couche ou un empilement de couches dont la composition peut être différente. A titre d'exemple, les couches 202 et 204 comprennent un alliage à base de fer, de cobalt et/ou de nickel, par exemple un alliage connu sous le nom de permalloy, de type Ni80Fe20 ou NiFeCo, ou, de préférence, du borure de fer et de cobalt FeCoB. A titre d'exemple, chacune des couches 202 et 204 comprend plusieurs couches, par exemple, à partir de sa surface en contact avec la couche tunnel 206 et sur une partie de son épaisseur, une couche de cobalt ou d'un alliage à base de cobalt 202-1, 204-1 ou par exemple de borure de fer et de cobalt FeCoB par exemple sur une épaisseur comprise entre 1 et 3 nm, puis une couche 202-2, 204-2 à base de fer de cobalt et/ou de nickel de 2 à 5 nm d'épaisseur. Ces couches 202-1 et 204-1 sont destinées à augmenter la polarisation des électrons et donc l'amplitude de la magnétorésistance. On pourra prévoir une couche de tantale, non représentée, d'épaisseur comprise entre 0,2 et 0,4 nm entre les couches 202-1 et 202-2 et entre les couches 204-1 et 204-2. Ainsi, chacune des couches 202 et 204, bien que pouvant comporter plusieurs matériaux différents, est presque entièrement ferromagnétique, par exemple à plus de 90 %.

A titre d'exemple, la couche tunnel 206 est en un oxyde, par exemple un oxyde d'aluminium, de magnésium, d'hafnium ou de zirconium. La couche tunnel peut avoir une épaisseur comprise entre 0,5 et 3 nm. Les couches ferromagnétiques peuvent avoir des épaisseurs comprises entre 2 et 20 nm, par exemple sensiblement égales.

La structure de la figure 3 peut être obtenue par des étapes successives de dépôt, sur le support, des couches 210, 204, 206, 202, et 208, de gravure des couches 208, 202, 206 et 204 jusqu'à la surface supérieure de la couche conductrice 210, et de réalisation des bornes. La structure de la figure 3 est donc particulièrement simple à réaliser.

Les figures 4A, 4B et 4C sont des vues de dessus schématiques d'exemples de capteurs de dispositifs de mesure de champs magnétiques faibles.

En figure 4A, le plot 302 a une forme rectangulaire, dont la longueur L et la largeur W sont dans un rapport d'aspect L/W compris entre 1 et 3, de préférence entre 1,1 et 1,5. En figure 4B, le plot 302 a une forme ovale, par exemple elliptique, dont la longueur L et la largeur W sont dans un rapport d'aspect L/W compris entre 1 et 3, de préférence compris entre 1 et 1,5. En figure 4C, le plot 302 a une forme de losange, dont la longueur L et la largeur W sont dans un rapport d'aspect L/W compris entre 1 et 3, de préférence entre 1,1 et 1,5.

A titre d'exemple, la largeur W des formes décrites en relation avec les figures 4A à 4C est comprise entre 3 et 30 um.

Les capteurs des figures 4A à 4C ont des formes allongées. De ce fait, en l'absence de champ magnétique autour du capteur, les aimantations antiparallèles des couches ferromagnétiques 202 et 204 vont s'aligner préférentiellement dans la direction d'allongement. Comme ceci a été mentionné, cette direction est placée de manière sensiblement orthogonale à la direction des branches 102A et 102B, c'est-à-dire, en fonctionnement, à la direction du champ magnétique alternatif produit dans les entrefers des branches.

On note que, dans le cas de la forme ovale de la figure 4B, un rapport d'aspect de 1 est possible, correspondant à une forme circulaire. Dans ce cas, bien que, en l'absence de champ magnétique autour du capteur, les aimantations antiparallèles soient sans direction préférentielle, les aimantations prennent la direction souhaitée spontanément lorsque le dispositif est en fonctionnement.

Par ailleurs, la direction d'aimantation préférentielle peut être obtenue par un recuit sous champ magnétique, ce qui permet des rapports d'aspect de 1 pour les formes décrites en relation avec les figures 4A, 4B et 4C.

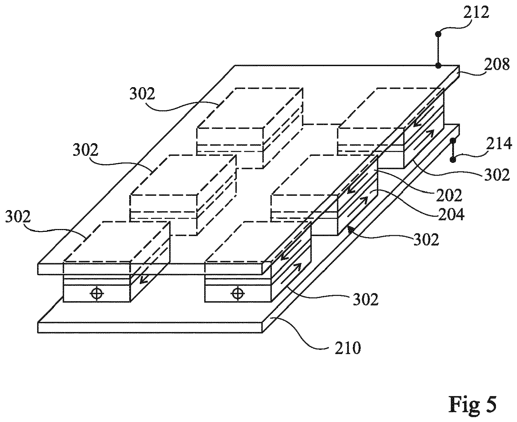

La figure 5 est une vue schématique en perspective d'un autre exemple de capteur d'un dispositif de mesure de champs magnétiques faibles. Le capteur peut être utilisé pour former les capteurs 200A et 200B du dispositif de la figure 1.

Le capteur comprend, sur une couche conductrice 210, des empilements similaires à celui du plot 302 de la figure 3, répétés dans la direction du plan des couches. Les couches ferromagnétiques 204 sont en contact avec la couche conductrice 210, et les couches ferromagnétiques 202 sont en contact avec une couche conductrice commune 208 qui recouvre l'ensemble de la structure. Les couches 208 et 210 sont reliées respectivement aux bornes 212 et 214. A titre d'exemple, les empilements 302 peuvent être disposés en ligne ou en matrice.

On obtient, dans chacun des empilements 302, un couplage antiparallèle entre couches ferromagnétiques d'intensité adaptée pour mesurer des champs magnétiques faibles. Par ailleurs, les empilements mis en parallèle permettent d'augmenter le rapport signal sur bruit de la mesure obtenue. On obtient ainsi un dispositif de mesure de champs magnétiques faibles particulièrement sensible et précis.

On note que les empilements 302 peuvent être formés simultanément au cours d'une même étape de gravure, et le procédé de réalisation du capteur est ainsi aisé à mettre en oeuvre.

Des modes de réalisation particuliers ont été décrits. Diverses variantes et modifications apparaîtront à l'homme de l'art. En particulier, bien qu'un mode de réalisation comprenne des capteurs comportant des empilements 302 en parallèle, d'autres modes de réalisation comprennent des capteurs comportant des empilements 302 reliés en série. En outre, d'autres modes de réalisation comprennent, à la place de chaque capteur 200A et 200B, plusieurs capteurs du type du capteur de la figure 5, reliés en série.

Bien que les modes de réalisation décrits comprennent un circuit magnétique en boucle comprenant deux branches sensiblement parallèles, le circuit magnétique peut comprendre plus de deux branches sensiblement parallèles. Les branches peuvent alors avoir leurs extrémités situées d'un même côté reliées entre elles et leurs extrémités situées de l'autre côté reliées entre elles. A titre de variante, chaque branche est séparée des autres branches et est munie d'un générateur de flux magnétique.

En outre, bien que les modes de réalisation décrits comprennent deux générateurs alternatifs alimentés par une tension alternative commune, il est possible de générer des flux magnétiques dans le circuit magnétique au moyen d'un seul générateur ou de plus de deux générateurs couplés magnétiquement au circuit magnétique.

En outre, bien que, dans les modes de réalisation décrits, les capteurs 200A, 200B soient reliés à des circuits de mesure et de détection synchrone dont les sorties sont reliées aux entrées d'un circuit de soustraction, les capteurs 200A et 200B peuvent être reliés à tout circuit adapté à fournir une différence entre les valeurs de résistance des capteurs démodulées à la fréquence de la tension alternative d'alimentation.

## Revendications

1. Dispositif de mesure d'un champ magnétique, comprenant :
un circuit magnétique comportant deux branches (102A, 102B) sensiblement parallèles, dans lesquelles des flux magnétiques (HA, HB) sont alternatifs et circulent en sens opposés ; et
un capteur (200A, 200B) situé dans chacune des branches, comprenant un empilement (302) de deux couches ferromagnétiques (202, 204) séparées par une couche de barrière isolante tunnel (206), lesdites couches ferromagnétiques ayant des aimantations (216, 218) orientées dans le plan des couches,
**caractérisé en ce que** chacune des deux couches ferromagnétiques n'est couplée magnétiquement que, d'une part, antiparallèlement à l'autre des deux couches ferromagnétiques, et, d'autre part, à un des flux magnétiques et au champ magnétique (Hx) à mesurer,
chacun des capteurs (200A, 200B) étant relié à un circuit de mesure et de détection synchrone (108A, 108B), les circuits de mesure et de détection synchrone ayant leurs sorties reliées à un circuit de soustraction (110), un flux de rétroaction parcourant le circuit s'ajoutant auxdits flux magnétiques, le flux de rétroaction étant fonction d'un signal de sortie du circuit de soustraction.

2. Dispositif selon la revendication 1, dans lequel chacun desdits empilements est disposé entre deux couches conductrices (208, 210) dont chacune est en contact avec l'une des couches ferromagnétiques (202, 204).

3. Dispositif selon la revendication 1 ou 2, dans lequel les couches ferromagnétiques (202, 204) ont des épaisseurs comprises entre 3 et 20 nm.

4. Dispositif selon l'une quelconque des revendications 1 à 3, dans lequel chacune des couches ferromagnétiques (202, 204) comprend une couche comprenant du cobalt (202-1, 204-1) en contact avec la couche tunnel.

5. Dispositif selon l'une quelconque des revendications 1 à 4, dans lequel chacune des couches ferromagnétiques (202, 204) comprend un alliage à base de nickel, de cobalt et/ou de fer.

6. Dispositif selon la revendication 5, dans lequel ledit alliage est le Ni80Fe20, le NiFeCo ou le FeCoB.

7. Dispositif selon l'une quelconque des revendications 1 à 6, dans lequel la couche tunnel (206) comprend un oxyde d'un matériau choisi dans le groupe comprenant l'aluminium, le magnésium, l'hafnium et le zirconium.

8. Dispositif selon l'une quelconque des revendications 1 à 7, dans lequel chacun desdits empilements (302) a une forme allongée vu de dessus.

9. Dispositif selon l'une quelconque des revendications 1 à 7, dans lequel chacun desdits empilements (302) vu de dessus a un rapport d'aspect (L/W) compris entre 1 et 3.

10. Dispositif selon l'une quelconque des revendications 1 à 9, dans lequel chacun des capteurs (200A, 200B), comprend des empilements supplémentaires identiques audit empilement, les empilements étant disposés entre deux couches conductrices (208, 210) communes en contact avec les couches ferromagnétiques (202, 204).

11. Dispositif selon l'une quelconque des revendications 1 à 9, dans lequel chacun des capteurs (200A, 200B), comprend des empilements supplémentaires identiques audit empilement, reliés en série.

## Patentansprüche

1. Vorrichtung zur Messung eines Magnetfeldes, die das Folgende enthält:
einen Magnetkreis mit zwei im Wesentlichen parallelen Schenkeln (102A, 102B), in denen Magnetflüsse (HA, HB) abwechselnd und in entgegengesetzten Richtungen fließen; und
einen Sensor (200A, 200B), der sich in jedem der Schenkel befindet und eine Stapelung (302) aus zwei ferromagnetischen Schichten (202, 204) umfasst, die durch eine isolierende Tunnelbarriereschicht (206) getrennt sind, wobei die ferromagnetischen Schichten Magnetisierungen (216, 218) haben, die in der Ebene der Schichten ausgerichtet sind,
**dadurch gekennzeichnet, dass** jede der beiden ferromagnetischen Schichten magnetisch nur einerseits antiparallel mit der anderen der beiden ferromagnetischen Schichten und andererseits mit einem der Magnetflüsse und dem zu messenden Magnetfeld (Hx) gekoppelt ist,
wobei jeder der Sensoren (200A, 200B) mit einer Mess- und Synchronerfassungsschaltung (108A, 108B) verbunden ist, wobei die Mess- und Synchronerfassungsschaltungen an ihren Ausgängen mit einer Subtraktionsschaltung (110) verbunden sind, wobei sich ein durch die Schaltung fließender Rückkopplungsfluss zu den Magnetflüssen hinzufügt, wobei der Rückkopplungsfluss Funktion von einem Ausgangssignal der Subtraktionsschaltung ist.

2. Vorrichtung nach Anspruch 1, wobei jede der Stapelungen zwischen zwei leitfähigen Schichten (208, 210) angeordnet ist, von denen jede mit einer der ferromagnetischen Schichten (202, 204) in Kontakt steht.

3. Vorrichtung nach Anspruch 1 oder 2, wobei die ferromagnetischen Schichten (202, 204) Dicken zwischen 3 und 20 nm aufweisen.

4. Vorrichtung nach einem der Ansprüche 1 bis 3, wobei jede der ferromagnetischen Schichten (202, 204) eine kobalthaltige Schicht (202-1, 204-1) umfasst, die mit der Tunnelschicht in Kontakt steht.

5. Vorrichtung nach einem der Ansprüche 1 bis 4, wobei jede der ferromagnetischen Schichten (202, 204) eine Legierung auf Nickel-, Kobalt- und/oder Eisenbasis umfasst.

6. Vorrichtung nach Anspruch 5, wobei es sich bei der Legierung um Ni80Fe20, NiFeCo oder FeCoB handelt.

7. Vorrichtung nach einem der Ansprüche 1 bis 6, wobei die Tunnelschicht (206) ein Oxid eines Materials enthält, das aus der Gruppe umfassend Aluminium, Magnesium, Hafnium und Zirkonium ausgewählt ist.

8. Vorrichtung nach einem der Ansprüche 1 bis 7, wobei jede der Stapelungen (302) in der Draufsicht eine längliche Form hat.

9. Vorrichtung nach einem der Ansprüche 1 bis 7, wobei jede der Stapelungen (302) in der Draufsicht ein Seitenverhältnis (L/W) zwischen 1 und 3 aufweist.

10. Vorrichtung nach einem der Ansprüche 1 bis 9, wobei jeder der Sensoren (200A, 200B) zusätzliche Stapelungen umfasst, die mit der genannten Stapelung identisch sind, wobei die Stapelungen zwischen zwei gemeinsamen leitfähigen Schichten (208, 210) angeordnet sind, die mit den ferromagnetischen Schichten (202, 204) in Kontakt stehen.

11. Vorrichtung nach einem der Ansprüche 1 bis 9, wobei jeder der Sensoren (200A, 200B) zusätzliche Stapelungen umfasst, die mit der genannten Stapelung identisch sind und in Reihe geschaltet sind.

## Claims

1. Device for measuring a magnetic field, comprising:
a magnetic circuit including two substantially parallel branches (102A, 102B) in which magnetic fluxes (HA, HB) are alternating and flow in opposite directions; and
a sensor (200A, 200B) situated in each of the branches, comprising a stack (302) of two ferromagnetic layers (202, 204) separated by a tunnel insulating barrier layer (206), said ferromagnetic layers having magnetizations (216, 218) oriented in the plane of the layers,
**characterized in that** each of the two ferromagnetic layers is magnetically coupled only in antiparallel with the other of the two ferromagnetic layers, on the one hand, and to one of the magnetic fluxes and to the magnetic field (Hx) to be measured, on the other hand,
each of the sensors (200A, 200B) being connected to a synchronous measurement and detection circuit (108A, 108B), the synchronous measurement and detection circuits having their outputs connected to a canceller circuit (110), a feedback flux passing through the circuit adding to said magnetic fluxes, the feedback flow being a function of an output signal of the canceller circuit.

2. Device according to claim 1, in which each of said stacks is arranged between two conductive layers (208, 210) each of which is in contact with one of the ferromagnetic layers (202, 204) .

3. Device according to claim 1 or 2, in which the ferromagnetic layers (202, 204) have thicknesses comprised between 3 and 20 nm.

4. Device according to any one of claims 1 to 3, in which each of the ferromagnetic layers (202, 204) comprises a layer comprising cobalt (202-1, 204-1) in contact with the tunnel layer.

5. Device according to any one of claims 1 to 4, in which each of the ferromagnetic layers (202, 204) comprises an alloy based on nickel, cobalt and/or iron.

6. Device according to claim 5, in which said alloy is Ni80Fe20, NiFeCo or FeCoB.

7. Device according to any one of claims 1 to 6, in which the tunnel layer (206) comprises an oxide of a material selected from the group comprising aluminium, magnesium, hafnium and zirconium.

8. Device according to any one of claims 1 to 7, in which each of said stacks (302) has an elongated shape when viewed from above.

9. Device according to any one of claims 1 to 7, in which each of said stacks (302) when viewed from above has an aspect ratio (L/W) comprised between 1 and 3.

10. Device according to any one of claims 1 to 9, in which each of the sensors (200A, 200B), comprises additional stacks identical to said stack, the stacks being arranged between two common conductive layers (208, 210) in contact avec the ferromagnetic layers (202, 204).

11. Device according to any one of claims 1 to 9, in which each of the sensors (200A, 200B), comprises additional stacks identical to said stack, connected in series.
